Europäisches Patentamt

European Patent Office

Office européen des brevets

(19)

(11) Veröffentlichungsnummer : **0 351 639 B1**

(12) **EUROPÄISCHE PATENTSCHRIFT**

(45) Veröffentlichungstag der Patentschrift :
07.09.94 Patentblatt 94/36

(51) Int. Cl.⁵ : **H03F 3/26, H03F 3/343**

(21) Anmeldenummer : **89112238.4**

(22) Anmeldetag : **05.07.89**

(54) **Eingangsschaltung für Hochfrequenzverstärker.**

(30) Priorität : **20.07.88 DE 3824556**

(43) Veröffentlichungstag der Anmeldung :
**24.01.90 Patentblatt 90/04**

(45) Bekanntmachung des Hinweises auf die
Patenterteilung :
**07.09.94 Patentblatt 94/36**

(84) Benannte Vertragsstaaten :
**AT BE CH DE ES FR GB GR IT LI LU NL SE**

(56) Entgegenhaltungen :
**FR-A- 2 528 259**
**US-A- 3 996 462**
**US-A- 4 644 295**
**US-A- 4 859 966**
**IEEE TRANS. CONSUMER ELECTRON., Band**
**CE-23, Nr. 2, Mai 1977, Seiten 129-136; L.**
**BLASER et al.: "An AM/FM radio subsystem**
**IC"**

(73) Patentinhaber : **TEMIC TELEFUNKEN**
**microelectronic GmbH**
**Theresienstrasse 2**
**D-74072 Heilbronn (DE)**
Patentinhaber : **Deutsche Thomson-Brandt**
**GmbH**
**Hermann-Schwer-Strasse 3**
**Postfach 1307**
**D-78003 Villingen-Schwenningen (DE)**

(72) Erfinder : **Böhme, Rolf, Dr.**
**Königsberger Strasse 23**
**D-7107 Bad Friedrichshall (DE)**
Erfinder : **Gleim, Günter**
**Oberer Sonnenbühl 22**
**D-7730 Villingen-Schwenningen (DE)**

(74) Vertreter : **Maute, Hans-Jürgen, Dipl.-Ing.**
**TEMIC TELEFUNKEN microelectronic GmbH**
**Postfach 35 35**
**D-74025 Heilbronn (DE)**

EP 0 351 639 B1

## Beschreibung

Eingangsschaltungen für Zwischen- und Hochfrequenzverstärker haben zum Teil einen unsymmetrischen Eingang und einen symmetrischen Ausgang. Als Eingangswiderstand werden vorwiegend Werte zwischen 50 $\Omega$ und 300 $\Omega$ benötigt, wie sie als Abschlußwiderstände von Kabeln oder Filtern in Gebrauch sind. Am Ausgang sind meist weitere Verstärkerstufen oder Selektionsmittel angeschlossen.

Anwendungsgebiete für solche Eingangsschaltungen sind beispielsweise Kabelendverstärker für breitbandige Übertragungskanäle, Antennenverstärker und ZF-Verstärker mit niedrigem Eingangswiderstand zur Anpassung an ein vorausgehendes Filter. Eine weitere, vorteilhafte Anwendung ist die Erstverstärkung der Signale lichtempfindlicher Dioden. Bei einer konventionellen Lösung des Problems verwendet man bipolare Transistoren in Basis- oder Zwischenbasis-Schaltung und setzt häufig Anpassungsüberträger ein.

Eine mehr integrationsgerechte Lösung ist aus der DP-PS 29 46 952 bekannt. Bei der bekannten Schaltung ist bei einer Differenzstufe aus zwei bipolaren Transistoren und einer Stromquelle an den miteinander verbundenen Emittern der beiden Transistoren ein dritter Transistor angeschlossen, und zwar mit seinem Emitter am negativen Anschlußpunkt der Stromversorgung oder Masse, mit seiner Basis an den Emittern der beiden Transistoren und mit dem Kollektor an einem Arbeitswiderstand, der zum positiven Anschlußpunkt der Stromversorgung führt. Weiter sind zwei Widerstände $R_a$, $R_b$ am Kollektor des dritten Transistors angeschlossen, die zu je einem Eingang (A, B) der Differenzstufe, d. h. zur Basis des ersten bzw. zweiten Transistors, führen. Bei einer solchen Differenzstufe ist das Potential der Eingänge auf etwa zwei Flußspannungen über Masse fixiert. Legt man ein Eingangssignal $U_e$ am Eingang A an, so ergibt der Wirkungsmechanismus dieser Schaltung die Entstehung eines umgekehrten Signals - $U_e$ am Eingang B und die Differenzstufe verhält sich so, als wäre sie mit 2 $U_e$ symmetrisch angesteuert. Als Eingangswiderstand wird dabei der halbe Wert des Widerstandes $R_a$ wirksam. Dies gilt jedoch nur für nicht zu hohe Frequenzen. Werden die Transistorparameter frequenzabhängig, so wird es auch der Eingangswiderstand. Die bekannte Schaltung hat hinsichtlich des Frequenzverhaltens weiterhin den Nachteil, daß sie eine unkompensierte Rückwirkung der Ausgänge der Differenzstufe über die Kollektor-Basis-Kapazität auf die Eingänge aufweist. Nachteilig wirkt sich bei der bekannten Schaltung auch der Rauschbeitrag des dritten Transistors aus. Zwar verschwindet dieser Beitrag, wenn beide Eingänge gleichartig beschaltet sind. Dies ist aber normalerweise nicht möglich. Das Rauschen des dritten Transistors trägt zum unvermeidlichen Rauschen der Differenzstufe bei.

Der Erfindung liegt die Aufgabe zugrunde, eine Eingangsschaltung für Hochfrequenzverstärker anzugeben, bei der die Transistorparameter eine möglichst geringe Frequenzabhängigkeit aufweisen und bei der die Rückwirkung vom Ausgang auf den Eingang möglichst gering ist. Diese Aufgabe wird bei einer Eingangsschaltung für Hochfrequenzverstärker nach der Erfindung durch die kennzeichnenden Merkmale des Anspruchs 1 gelöst.

Bei der Eingangsschaltung nach der Erfindung entsprechen Strombedarf, Rauschen und die Übertragungskennlinie weitgehend den Eigenschaften einer einfachen Differenzstufe. Der Eingangswiderstand ist vom Stromfluß abhängig und kann deshalb auch gesteuert oder elektronisch eingestellt werden. Die Frequenzabhängigkeit des Eingangswiderstandes ist gering und die Schaltung besitzt einen Abschirmeffekt zwischen Eingang und Ausgang, so daß wesentlich höhere Frequenzen als bei der bekannten Schaltung übertragen werden können.

Anhand einer Zeichnung wird nun die Erfindung in Ausführungsbeispielen näher erläutert. Dazu zeigen

Fig. 1:     eine Anordnung gemäß DE-PS 29 46 952

Fig. 2:     eine Eingangsschaltung gemäß der Erfindung mit symmetrischem Ausgang

Fig. 3:     eine typische Übertragungskennlinie dieser Eingangsschaltung

Fig. 4:     eine Eingangsschaltung mit steuerbarem Eingangswiderstand und nachgeschaltetem Differenzverstärker

Fig. 5:     eine Eingangsschaltung mit unsymmetrischem Ausgang

Fig. 6:     eine Eingangsschaltung mit Basisstromkompensation.

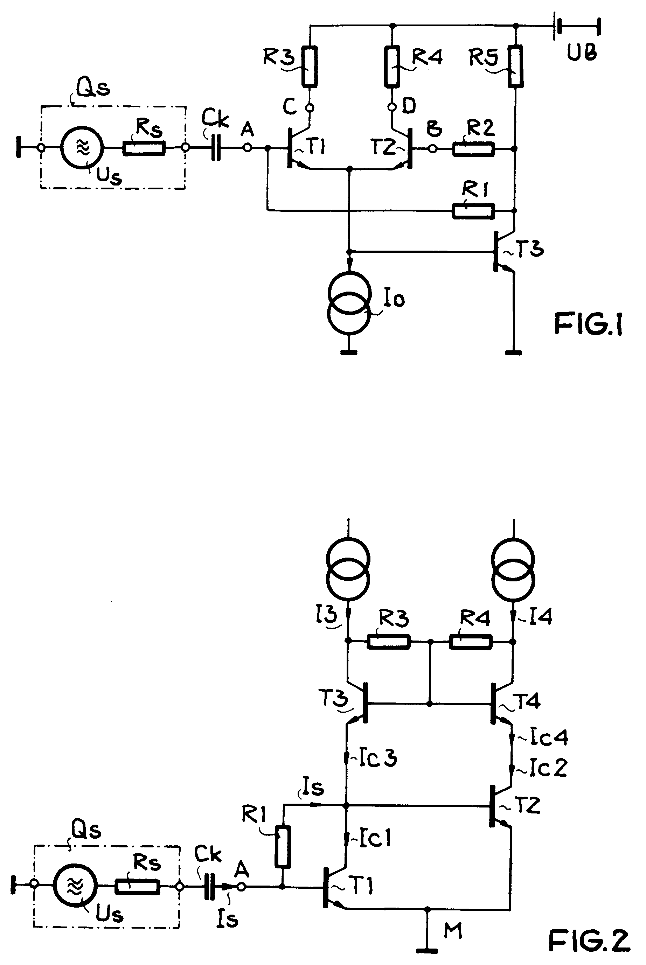

Die in Figur 1 dargestellte Schaltung nach der DE-PS 29 46 952 besteht aus der Differenzstufe mit den Transistoren T1 und T2, der Stromquelle Io und den beiden Arbeitswiderständen R3 und R4. Der wesentliche Effekt dieser Schaltung wird durch den Transistor T3 erzeugt, dessen Emitter an Masse, dessen Basis am Verbindungspunkt der Emitter der Transistoren T1, T2 und dessen Kollektor über den Arbeitswiderstand R5 an der Versorgungsspannung $U_B$ angeschlossen ist. Die Widerstände R1, R2 verbinden den Kollektor des dritten Transistors T3 mit den Eingangsklemmen A, B der Differenzstufe, wobei R2 auch 0 sein kann. Der Transistor T3 ist über die Transistoren T1, T2 der Differenzstufe, die in diesem Fall als Emitterfolger wirken, gegengekoppelt. Der Arbeitspunkt des Transistors T3 stellt sich entsprechend dem Strom durch R5 ein.

Das Potential der Eingangsklemmen A, B wird damit fixiert. Führt man dem Eingang A eine Spannungsänderung $U_e$ zu, so entsteht am Eingang B eine Änderung um etwa - $U_e$. Da über R1 somit 2 $U_e$ abfallen, wird

der Eingangswiderstand an Klemme A näherungsweise R1/2. Einerseits ist dies ein Vorteil dieser bekannten Anordnung, weil der hochfrequenztechnisch benötigte Eingangswiderstand erdfrei erzeugt wird und keine weiteren Maßnahmen zur Führung des zweiten Einganges B der Differenzstufe erforderlich sind. Andererseits ergibt sich über die aktive Erzeugung des Eingangswiderstandes R1/2 am Eingang A unter Mitwirkung von 3 Transistoren ein relativ beschränkter Frequenzbereich. Bei einer integrierten Ausführung besteht auch keine einfache Möglichkeit, Temperaturabhängigkeit und Streuung des Widerstandes R1 zu korrigieren. Für eine Anwendung bei höheren Frequenzen, etwa bei 10,7 MHz, ist auch die Rückwirkung der Ausgänge C, D auf die Eingänge A, B von Nachteil, zu deren Unterdrückung meist noch zusätzliche Maßnahmen erforderlich sind. Schließlich ist der Rauschbeitrag, den der dritte Transistor zum Gesamtrauschen liefert, nicht gering und beeinträchtigt die Funktion als Vorverstärker.

Die Figur 2 zeigt ein Ausführungsbeispiel der erfindungsgemäßen Schaltung. Die Schaltung der Figur 2 enthält 4 Transistoren T1 ... T4 gleichen Leitungstyps. Sie wird durch folgende Verbindungsliste beschrieben:

Emitter T1 - Emitter T2 - Masse (Bezugsknoten);

Eingang A - Basis T1 - Widerstand R1 (kann 0 sein);

Kollektor T1 - Emitter T3 - Widerstand R1 - Basis T2;

Kollektor T2 - Emitter T4;

Basis T3 - Basis T4 - Widerstand R3 - Widerstand R4 (einer von beiden kann 0 sein);

Kollektor T3 - Widerstand R3 - Stromquelle I3 - Ausgang C;

Kollektor T4 - Widerstand R4 - Stromquelle I4 - Ausgang D.

Über einen Koppelkondensator Ck ist die Signalquelle Qs, die durch eine Spannungsquelle Us und Innenwiderstand Rs dargestellt ist, angeschlossen.

Um den Wirkungsmechanismus vereinfacht darzustellen, kann man die Basisströme zunächst vernachlässigen. Weiterhin sei I3 = I4 und R3 = R4 angenommen. Im Ruhezustand fällt dann über R1 keine Spannung ab und die beiden Transistoren T1, T2 haben den gleichen Arbeitspunkt. Der Arbeitsstrom aller Transistoren ist untereinander gleich. Ein Signalstrom Is erzeugt einen Spannungsabfall R1·Is über dem Widerstand R1, der zugleich die Differenz der beiden Basisspannungen des ersten und zweiten Transistors T1, T2 ist. Dem ersten und zweiten Transistor T1, T2 fließt die Stromsumme I3 + I4 + Is zu. Dieser Gesamtstrom wird zwischen dem ersten und zweiten Transistor aufgeteilt und in die Transistoren T3, T4 weitergeleitet, wobei beim ersten Transistor der Signalstrom Is wieder subtrahiert wird. Die Aufteilung kann mit Hilfe der Gleichung des idealen Transistors

$$Ic = Ico (e^{UBE/UT} - 1)$$

berechnet werden, wobei Ico der Transferreststrom und UT = kT/q die Temperaturspannung sind. Es ergibt sich dann als Ausgangsspannung zwischen den Ausgangsklemmen C, D

$$UCD = (R3 + R4) \frac{I3 + Is - a * I4}{1 + a}$$

mit $a = e^{IsR1/UT}$.

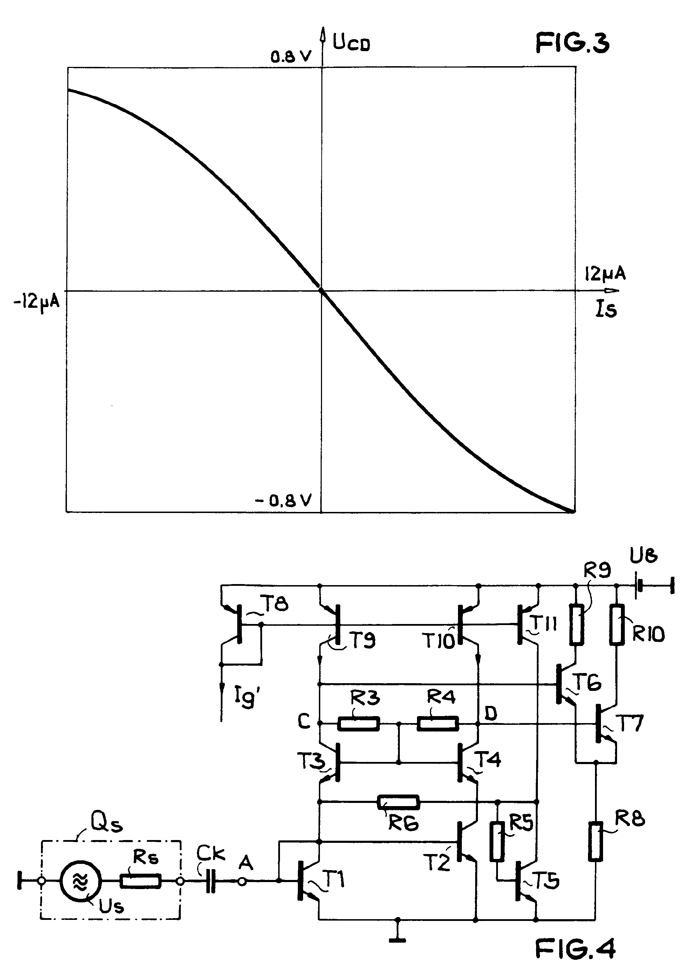

Die Fig. 3 zeigt die Abhängigkeit der Ausgangsspannung UCD von Is für I3 = I4 = 100 μA, R1 = 5 kΩ, R3 = R4 = 5 kΩ, UT = 26 mV (300 °K). Bis auf eine geringe Unsymmetrie, die durch das Glied Is im Zähler der Formel verursacht wird, gleicht die Kennlinie der der Schaltung nach Fig. 1. Durch Linearisierung in der Umgebung von Is = 0 erhält man mit Ig = I3 + I4 und Rg = R3 + R4 den Übertragungswiderstand

$$\frac{UCD}{Is} = \frac{1}{4} (2 - Ig \frac{R1}{UT}) Rg,$$

die Spannungsverstärkung

$$\frac{UCD}{\Delta UA} = \frac{IgRg}{2 UT} \frac{2 UT - IgR1}{2 UT + IgR1}$$

und den Eingangswiderstand

$$Re = \frac{2 UT}{Ig} + \frac{R1}{2}$$

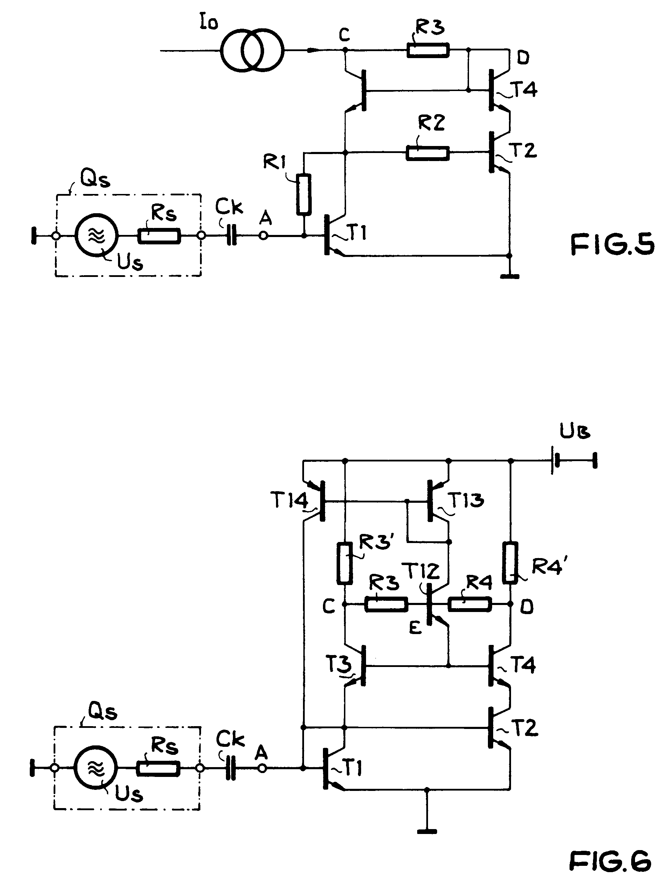

Besonderes Interesse verdienen die Fälle R1 = 0 und R1 >> 2 UT/Ig. Der Fall R1 = 0 ist in Fig. 4 dargestellt. Der Eingangswiderstand ist dann Re = 2 UT/Ig und kann über die Einstellung oder Steuerung von Ig′ leicht beeinflußt werden. Zu diesem Zweck ist eine Stromspiegelschaltung mit den Transistoren T8, T9 und T10 vorgesehen, die den Strom Ig′ in die beiden Ströme I3, I4 umsetzt. Um z. B. einen Eingangswiderstand von 75 Ω zu erzeugen, benötigt man einen Strom I3 + I4 = 2 UT/Re = 0.33 mA bei Zimmertemperatur. Das zeigt, daß auch niedrige Eingangswiderstände stromsparend erreichbar sind. Der Wert der Spannungsverstärkung entspricht trotzdem dem der einfachen Differenzstufe oder der Schaltung nach Fig. 1. Dabei wird auch die höchste Grenzfrequenz erreicht. Der Fall R1 >> 2 UT/Ig ist in Fig. 2 und in Fig. 5 dargestellt. Der Eingangswiderstand nähert sich R1/2 wie in der bekannten Schaltung nach Fig. 1. Die Spannungsverstärkung hat fast den gleichen Wert wie vorher, aber mit umgekehrtem Vorzeichen. Der Übertragungswiderstand wächst mit R1 und hat ebenfalls umgekehrtes Vorzeichen. Die erreichbare Grenzfrequenz sinkt gegenüber dem Fall R1 = 0 ab, ist aber immer noch wesentlich höher als in der Anordnung nach Fig. 1.

Ein weiterer Vorteil der erfindungsgemäßen Anordnung besteht darin, daß die Spannung der beiden miteinander verbundenen Basen des dritten und vierten Transistors T3, T4 relativ zum Bezugsknoten M nicht vom Signal abhängt. Erst bei Übersteuerung kommt es zum Absinken dieser Spannung. Somit kann der Eingangskreis nicht durch kapazitive Effekte von den Basen der beiden Transistoren T3, T4 gestört werden. Insbesondere wird wie bei einer Kaskode-Stufe der Eingangskreis von den Ausgängen C, D abgeschirmt.

Zum Rauschverhalten ist zu bemerken, daß die beiden Transistoren T3, T4 keinen wesentlichen Rauschbeitrag liefern, da sie den Strom nur weiterleiten und nicht steuern. Das Rauschen des ersten und zweiten Transistors T1, T2 ist aber dem Rauschen einer entsprechenden Differenzstufe äquivalent. Somit ergibt sich für die erfindungsgemäße Lösung ein besseres Rauschverhalten als für die Anordnung nach Fig. 1.

In einer Anordnung nach Fig. 4 wird die elektrische Symmetrie dadurch etwas gestört, daß die Basisströme des ersten und zweiten Transistors T1, T2 über den Transistor T3 zugeführt werden, während der andere Pfad mit dem Transistor T4 unbelastet bleibt. Dies führt zu einer fehlerhaften Gleichspannung zwischen den Ausgangsklemmen C, D. Falls dies stört, kann eine Kompensation mit einem Simulationstransistor T5, der über einen weiteren Transistor T11 des Stromspiegels versorgt wird, erfolgen.

Zu diesem Zweck sind am Kollektor des Transistors T5 zwei Widerstände R5, R6 angeschlossen, wobei der Widerstand R5 mit der Basis von T5 und der Widerstand R6 mit dem Eingangsanschluß verbunden ist. Die gewünschte Kompensation wird erreicht, wenn ungefähr R6 = R5/2 gewählt wird.

Eine weitere Möglichkeit der Basisstrom-Kompensation ist in Fig. 6 dargestellt. Dabei ist ein Transistor T12 mit dem Emitter am Verbindungspunkt der beiden Basen der Transistoren T3, T4 und mit der Basis am Verbindungspunkt E der beiden Widerstände R3, R4 angeschlossen, während der Kollektor des Transistors T12 mit dem Eingang eines Stromspiegels aus den Transistoren T13 und T14 verbunden ist. Der Ausgang des Stromspiegels, der vom Kollektor des Transistors T14 gebildet wird, ist mit der Eingangsklemme A verbunden. Auf diese Weise wird der Basisstrom der Transistoren T3, T4, der dem Basisstrom der Transistoren T1, T2 sehr ähnlich ist, durch den Transistor T12 aufgenommen und dem Schaltungseingang über dem Stromspiegel T13, T14 zugeführt. Dabei wird kein zusätzlicher Strom benötigt wie in der Anordnung nach Fig. 4. Außerdem kann es von Vorteil sein, daß das Potential der Ausgänge C, D um die Basis-Emitter-Spannung des Transistors T12 über dem Potential der Basen der Transistoren T3, T4 liegt, wodurch ein größerer Spannungshub an den Ausgängen C, D der Anordnung möglich wird.

Mit der Einfügung des Widerstandes R1 gemäß Fig. 2 oder Fig. 5 wird die Unsymmetrie der Ströme durch die Transistoren T3, T4 verbessert, weil der Spannungsabfall über R1 die Basis-Emitter-Spannung des Transistors T1 vermindert und damit dessen Kollektorstrom reduziert. Bei größerem Widerstand R1 kommt es aber zu einer Überkompensation. Zur Vermeidung dieses Effektes ist auch vorgesehen, der Basis des zweiten Transistors T2 einen Widerstand R2 vorzuschalten, wie in Fig. 5 dargestellt ist.

Die Schaltung nach Fig. 6 erlaubt eine größere Aussteuerung der Ausgänge C, D, weil die Kollektoren der Transistoren T3, T4 ein höheres Potential als die miteinander verbundenen Basen führen. Falls diese Eigenschaft benötigt wird und auf die Basisstromkompensation verzichtet werden kann, können die Transistoren T13, T14 weggelassen und der Kollektor des Transistors T12 mit der Versorgungsspannung UB verbunden werden. Es ist auch möglich, zwischen dem Verbindungspunkt E der Widerstände R3, R4 und der Basis der Transistoren T3, T4 eine oder mehrere Dioden oder/und einen Widerstand einzufügen.

In den meisten Anwendungen wird ein symmetrischer Ausgang mit I3 = I4 und R3 = R4 erwünscht sein, wie im Beispiel nach Fig. 4 mit Ankopplung einer Differenzstufe gezeigt ist. Je nach dem Verhältnis I3/I4 und R3/R4 lassen sich auch unsymmetrische Ansteuerungs- und Potentialverhältnisse einstellen. In Fig. 5 ist ein Beispiel mit I4 = 0 und R4 = 0 dargestellt, bei dem der gesamte Versorgungsstrom Io einseitig zugeführt wird und der Transistor T4 nur als Diode arbeitet. Das verstärkte Signal erscheint dann einseitig am Ausgang C, während der Ausgang D nur noch ein Ruhepotential führt.

## Patentansprüche

1. Eingangsschaltung für Hochfrequenzverstärker mit vier Transistoren gleichen Leitfähigkeitstyps, dadurch gekennzeichnet, daß die Emitter des ersten und zweiten Transistors (T1, T2) mit einem Bezugspunkt (M) verbunden sind, daß die Basis des ersten Transistors (T1) den Eingang (A) der Schaltung bildet, daß die Basis des zweiten Transistors (T2) am Kollektor des ersten Transistors (T1) angeschlossen ist, daß der Kollektor des ersten Transistors (T1) mit dem Emitter des dritten Transistors (T3) und der Kollektor des zweiten Transistors (T2) mit dem Emitter des vierten Transistors (T4) verbunden sind, daß die Basen des dritten und vierten Transistors (T3, T4) untereinander verbunden sind und daß wenigstens einer der Kollektoren des dritten oder vierten Transistors (T3, T4) mit einer Stromzuführung (I3, I4) verbunden ist.

2. Eingangsschaltung nach Anspruch 1, dadurch gekennzeichnet, daß die Basis und der Kollektor des ersten Transistors (T1) untereinander verbunden sind.

3. Eingangsschaltung nach Anspruch 1, dadurch gekennzeichnet, daß ein Widerstand (R1) zwischen die Basis und den Kollektor des ersten Transistors (T1) geschaltet ist.

4. Eingangsschaltung nach einem der Ansprüche 1 bis 3, dadurch gekennzeichnet, daß der Kollektor des dritten Transistors (T3) mit der Basis des dritten Transistors (T3) und der Kollektor des vierten Transistors (T4) mit der Basis des vierten Transistors (T4) verbunden sind, wobei mindestens eine Verbindung über einen Widerstand (R3, R4) erfolgt.

5. Eingangsschaltung nach einem der Ansprüche 1 bis 3, dadurch gekennzeichnet, daß die Kollektoren des dritten und vierten Transistors (T3, T4) mit einem Knoten (E) verbunden sind, wobei mindestens eine Verbindung über einen Widerstand (R3, R4) erfolgt, und daß der Knoten (E) über eine weitere Impedanz, z. B. der Basis-Emitter-Strecke eines Transistors (T12), mit den Basen des dritten und vierten Transistors (T3, T4) verbunden ist.

6. Eingangsschaltung nach einem der Ansprüche 1 bis 5, dadurch gekennzeichnet, daß der Basis des zweiten Transistors (T2) ein Widerstand (R2) vorgeschaltet ist.

7. Eingangsschaltung nach einem der Ansprüche 1 bis 6, dadurch gekennzeichnet, daß wenigstens einer der Basen des ersten und zweiten Transistors (T1, T2) ein Strom zugeführt wird, der etwa dem Basisstrom entspricht.

## Claims

1. An input circuit for high-frequency amplifiers with four transistors of the same conductivity type, characterised in that the emitters of the first and second transistors (T1, T2) are connected to a reference point (M), that the base of the first transistor (T1) forms the input (A) of the circuit, that the base of the second transistor (T2) is connected to the collector of the first transistor (T1), that the collector of the first transistor (T1) is connected to the emitter of the third transistor (T3) and the collector of the second transistor (T2) is connected to the emitter of the fourth transistor (T4), that the bases of the third and fourth transistors (T3, T4) are connected to one another and that at least one of the collectors of the third or fourth transistor (T3, T4) is connected to a current supply (I3, I4).

2. An input circuit as claimed in Claim 1, characterised in that the base and the collector of the first transistor (T1) are connected to one another.

3. An input circuit as claimed in Claim 1, characterised in that a resistor (R1) is connected between the base and the collector of the first transistor (T1).

4. An input circuit as claimed in one of claims 1 to 3, characterised in that the collector of the third transistor (T3) is connected to the base of the third transistor (T3) and the collector of the fourth transistor (T4) is connected to the base of the fourth transistor (T4), where at least one connection takes place via a resistor (R3, R4).

5. An input circuit as claimed in one of Claims 1 to 3, characterised in that the collectors of the third and fourth transistors (T3, T4) are connected to a node (E), where at least one connection takes place via a resistor (R3, R4), and that the node (E) is connected via a further impedance, for example the base-emitter path of a transistor (T12), to the bases of the third and fourth transistors (T3, T4).

6. An input circuit as claimed in one of Claims 1 to 5, characterised in that a resistor (R2) is connected in series with the base of the second transistor (T2).

7. An input circuit as claimed in one of Claims 1 to 6, characterised in that at least one of the bases of the first and second transistors (T1, T2) is supplied with a current which corresponds approximately to the base current.

**Revendications**

1. Circuit d'entrée pour des amplificateurs à haute fréquence comportant quatre transistors de même type de conductibilité, caractérisé en ce que les émetteurs des premier et deuxième transistors (T1, T2) sont reliés avec un point de référence (M), que la base du premier transistor (T1) forme l'entrée (A) du circuit, que la base du deuxième transistor (T2) est raccordée au collecteur du premier transistor (T1), que le collecteur du premier transistor (T1) est relié avec l'émetteur du troisième transistor (T3) et le collecteur du deuxième transistor (T2) est relié avec l'émetteur du quatrième transistor (T4), que les bases des troisième et quatrième transistors (T3, T4) sont reliées entre elles et qu'au moins un des collecteurs des troisième ou quatrième transistors (T3, T4) est relié avec une amenée de courant (I3, I4).

2. Circuit d'entrée selon la revendication 1, caractérisé en ce que la base et le collecteur du premier transistor (T1) sont reliés entre eux.

3. Circuit d'entrée selon la revendication 1, caractérisé en ce qu'une résistance (R1) est mise en circuit entre la base et le collecteur du premier transistor (T1).

4. Circuit d'entrée selon une des revendications 1 à 3, caractérisé en ce que le collecteur du troisième transistor (T3) est relié avec la base du troisième transistor (T3) et le collecteur du quatrième transistor (T4) est relié avec la base du quatrième transistor (T4), au moins une liaison ayant lieu par l'intermédiaire d'une résistance (R3, R4).

5. Circuit d'entrée selon une des revendications 1 à 3, caractérisé en ce que les collecteurs des troisième et quatrième transistors (T3, T4) sont reliés avec un noeud (E), au moins une liaison ayant lieu par l'intermédiaire d'une résistance (R3, R4), et en ce que le noeud (E) est relié, par l'intermédiaire d'une autre impédance, par exemple le tronçon base-émetteur d'un transistor (T12), avec les bases des troisième et quatrième transistors (T3, T4).

6. Circuit d'entrée selon une des revendications 1 à 5, caractérisé en ce qu' une résistance (R2) est mise en circuit en amont de la base du deuxième transistor (T2).

7. Circuit d'entrée selon une des revendications 1 à 6, caractérisé en ce qu'au moins un courant est amené à une des bases des premier et deuxième transistors (T1, T2), qui correspond à peu près au courant de base.

EP 0 351 639 B1

FIG.1

FIG.2

7

FIG.3

FIG.4

FIG.5

FIG.6